Europäisches Patentamt

European Patent Office

Office européen des brevets

(19)

(11) Publication number: **0 210 371**
A1

# EUROPEAN PATENT APPLICATION

(12)

(21) Application number: **86107248.6**

(22) Date of filing: **28.05.86**

(51) Int. Cl.⁴: **H 01 L 23/48**

(30) Priority: **29.05.85 JP 115682/85**

(43) Date of publication of application:
**04.02.87 Bulletin 87/6**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Sato, Kazuhide**
**2-1-20 501, Matsukage-Cho Naka-Ku**
**Yokohama-Shi Kanagawa-Ken(JP)**

(72) Inventor: **Ikebe, Kimihiro**
**C-529, Toshiba Isogo Dai6Ryo 2-8-2, Shiomidai**
**Isogo-Ku Yokohama-Shi Kanagawa-Ken(JP)**

(72) Inventor: **Sakurai, Toshiharu**
**622, Kopu Nomura 250-1, Shimokurata-Cho**
**Totsuka-Ku Yokohama-Shi Kanagawa-Ken(JP)**

(74) Representative: **Eitle, Werner, Dipl.-Ing. et al,**
**Hoffmann, Eitle & Partner Patentanwälte Arabellastrasse**
**4**
**D-8000 München 81(DE)**

(54) Semiconductor device having a plurality of leads.

(57) A semiconductor device which has a semiconductor chip
(4, 28, 31), a plurality of leads (3) and a plurality of inter-
mediate leads (12). The intermediate leads connect electrodes
of the semiconductor chip to inner ends of the leads. The inter-
mediate leads are formed on a insulating supporting sheet
(11), for example polyimide sheet, transparent glass sheet.
The connection is performed by solder or gold bumps (13),
etc.

F I G. 2

SEMICONDUCTOR DEVICE   TITLE MODIFIED see front page

## BACKGROUND OF THE INVENTION

This invention relates to a semiconductor device, especially to the one which requires high integration density.

A conventional mold type semiconductor device uses a leadframe which has a bed in the center on which a semiconductor chip is mounted and leads which radiate from the proximity of the bed to the outside of a package. At the inner end of the lead a bond wire from an electrode of the chip is connected. After the wiring, the leadframe and the chip are molded by a molding compound except the outer leads which are projecting parts of the leads.

The leadframe is obtained by pressing or etching a thin metal sheet of ferroalloy or copper alloy. The pitch of inner ends of the leads depends on the thickness of the leadframe material. That is, the minimum width of the inner lead end which can be formed by pressing is almost the same as the thickness of the sheet. In order to avoid the shortcircuit between the neiboring leads when a lead bending occurs, it is necessary to provide a distance of at least the thickness of the material between the neiboring leads. Therefore, the necessary lead pitch will be twice the leadframe material thickness.

For example, the necessary thickness of the leadframe which is hard to incur a lead bending or a lead breaking during the wire bonding and molding process, etc. is at least 0.15 mm for the conventional dual inline package (DIP). As described above, in a case of using a 0.15 mm thick metal sheet, the pitch of the inner lead ends becomes 0.3 mm. Therefore, if the length of a side of the bed is 6 mm, the number of leads which can be arranged for one side is 20, and 80 for four sides at the most.

There have been proposed various types of highly integrated semiconductor devices which have a lot of leads. First, in order to increase the number of leads without changing the lead pitch and the lead width, the distance between the inner end of the lead and the bed is increased. However, in this method, the lengths of bond wires which extend from electrodes on the chip to the lead ends are increased, which brings about the difficulty of wire bonding and low reliability caused by touching between wires, wires and the bed, wires and the chip edge.

The second method is to enlarge the semiconductor chip and the bed. For example, if the number of electrodes become double in the aforementioned example, the necessary length of one bed side will be 12 mm. However, increase in the number of electrodes is undesirable because the size of the semiconductor chip and the bed is standardized, and it is also uneconomical because the number of chips obtained from a standardized wafer is decreased.

The third method is to decrease the pitch and width of the inner ends of leads. However, this method has a difficulty in processing. Moreover, there is a problem of lead touching because leads are so thin that they have insufficient resilience. Polyimide tape is often bridged between leads for reinforcement, which is insufficient and it is troublesome to stick the polyimide tape. As to connection methods between the chip and leadframe other than wire bonding, flip chip method which uses solder or gold bump and TAB (Tape Automated Bonding), etc. are known. However, these methods have limits in the high integration.

When mounting a flip chip, there is another problem in positioning. That is, it is difficult to locate the chip in a correct position by adjusting the outline of the chip, because it is impossible to observe the bumps and leads bonded.

## SUMMARY OF THE INVENTION

It is, accordingly, an object of the present invention to overcome the disadvantage in the prior art semiconductor device and to provide a highly reliable semiconductor device which has a lot of leads arranged with high density.

It is another object of the present invention to provide a semiconductor device whose semiconductor chip can be precisely positioned.

According to one aspect of the present invention, there is provided a semiconductor device comprising a semiconductor chip, a plurality of leads, the inner ends of the leads being located apart from the side of the chip, and the outer ends of the leads projecting from a package, and a plurality of intermediate leads formed on an insulating supporting sheet, one ends of the intermediate leads being connected to the electrodes of the chip, the other ends of the intermediate leads being connected to the inner ends of the leads corresponding to the electrodes, and the intermediate leads being made narrower than the leads.

According to another aspect of the present invention, there is provided a semiconductor device comprising a semiconductor chip, a plurality of leads, inner ends of the leads being located apart from the side of the chip, and the outer ends of the leads projecting from a package, the surface of the leads being flush with the surface of the electrodes of the semiconductor chip, and a plurality of intermediate leads formed on an insulating supporting sheet which has an opening in the center thereof, inner ends protruding from the opening. and outer ends protruding from the side of the semiconductor chip, the intermediate leads being connected to the electrodes of the semiconductor chip and the leads placing the insulating supporting sheet between the intermediate leads and the leads/substrate of the semiconductor chip.

## BRIEF DESCRIPTION OF THE DRAWINGS:

The preferred embodiments of the present invention will now be described by way of examples with reference to the accompanying drawings in which:

Fig. 1 is a plan view describing the connection of semiconductor chip, intermediate leads and leads;

Fig. 2 is a sectional elevation of Fig. 1;

Fig. 3 is a plan view showing intermediate leads formed on a supporting sheet;

Fig. 4 is a plan view of completed intermediate leads;

Fig. 5 is a sectional elevation of another type of semiconductor device;

Fig. 6 is a plan view of intermediate leads used in the semiconductor device shown in Fig. 5;

Fig. 7 is a sectional elevation showing further embodiment of the present invention;

Fig. 8 is a plan view of another type of intermediate leads;

Fig. 9 is a sectional elevation showing still further embodiment of the present invention;

Fig. 10 is a sectional elevation of intermediate leads formed on a transparent sheet and a chip used in another embodiment of the present invention; and

Fig. 11 is a plan view of the intermediate leads and semiconductor chips shown in Fig. 10.

## DESCRIPTION OF THE PREFERRED EMBODIMENT

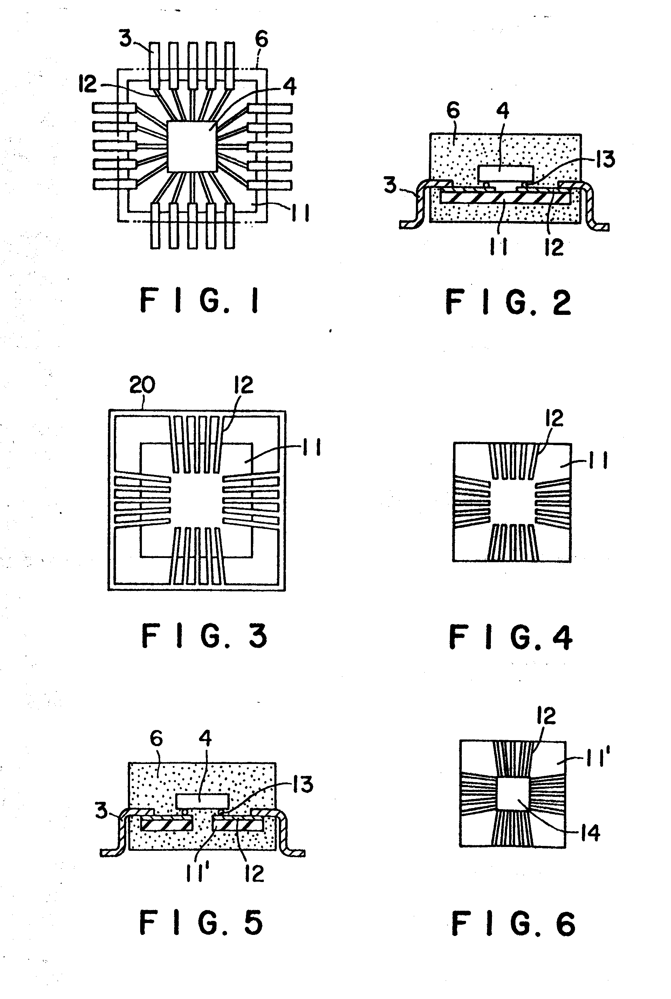

Fig. 1 shows a perspective plan view of an embodiment of the present invention, in which the molded area is described by a chain line, and Fig. 2 shows a sectional elevation of the center of Fig. 1.

In this embodiment, the inner ends of leads 3 are located apart from the sides of a chip 4 within a molding area 6, and the semiconductor chip 4 is faced down. Its electrodes and the inner ends of the leads 3 are bonded to intermediate leads supported on the insulating substrate 11 such as a polyimide sheet. These intermediate leads 12 are formed to radiate from the center of the supporting sheet 11 as shown in Fig. 4. The inner ends of the intermediate leads 12 and the electrode (not shown) of the chip 4 are connected by means of solder or gold bumps 13. For this connection, for example, projections of 20 to 50 µm thick are fromed on the electrodes of the semiconductor chip 4 and/or on the end parts of the intermediate leads 12, and then corresponding parts are bonded by means of, for example, thermal compression. The outer ends of the intermediate leads 12 and the inner ends of the leads 3 are connected by various methods such as thermal compression, soldering, and laser welding, etc.

Thus the connection using the intermediate leads 12 is performed. The whole assembly excluding external leads is sealed by molding thermosetting plastic polymer 6 such as epoxy resin compound.

The intermediate leads 12 can be manufactured by various methods. For example, they are made by patterning through etching foil of ferroalloy of the leadframe, e.g., 42 alloy (Ni: 42%, Fe: remaining) or copper alloy adhering to a supporting sheet. The intermediate leads 12 can also be manufactured by bonding the fine pitch leads with a frame 20 which have been patterned by etching or pressing onto the supporting sheet 11 as shown in Fig. 3 and cutting protruding portion of the intermediate leads at the end of the side of the supporting sheet 11 as shown in Fig. 4.

Another method for manufacturing the intermediate leads is to deposit the material for intermediate leads on the supporting sheet 11.

Figs. 5 and 6 show another embodiment of the present invention and correspond to Figs. 2 and 4, respectively, except the difference wherein, in Figs. 5 and 6, an opening 14 is provided in the center of the supporting sheet 11' in order to achieve good flow of a molding compound. In this embodiment, a molding compound flows through this opening, thus attaining a complete sealing.

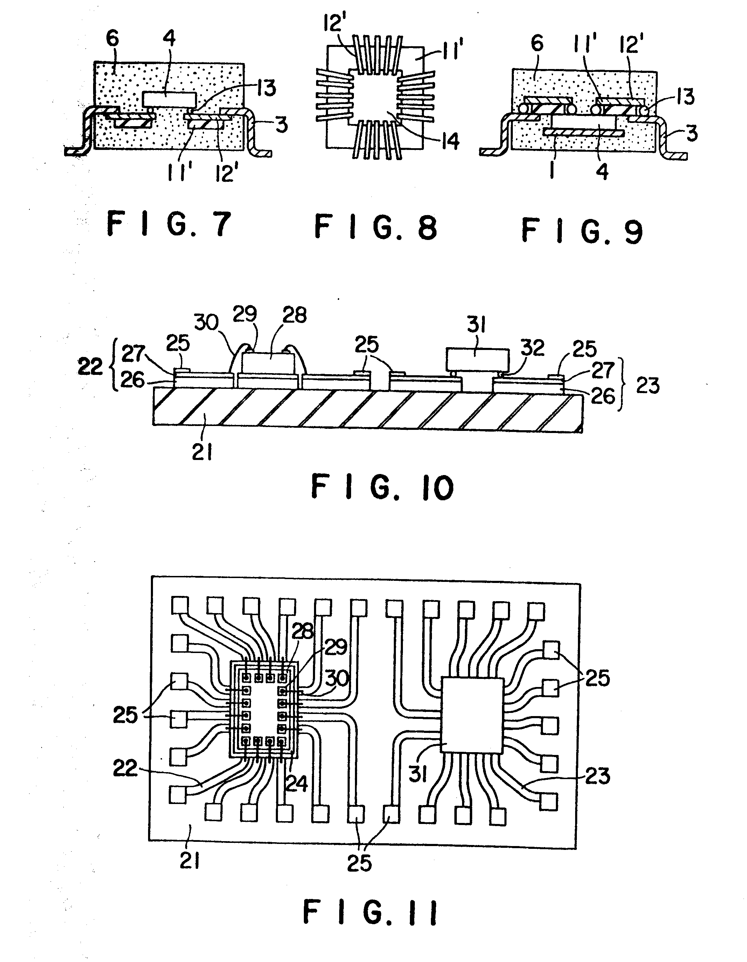

Figs. 7 and 8 show another embodiment of the present invention and correspond to Figs. 2 and 4, respectively.

In this embodiment, the inner ends of intermediate leads 12' protrude from the opening 14 of the supporting sheet 11' and the outer ends of the intermediate leads 12' protrude from the outer sides of the supporting sheet 11'.

In this embodiment, good sticking characteristics between the supporting sheet and the sealing compound are obtained because the size of the supporting sheet is reduced.

The intermediate leads 12' used in the embodiment are formed by bonding the thin leads made by etching or pressing the material thinner than the leadframe material.

Fig. 9 shows a semiconductor device which uses the intermediate leads 12' as shown in Fig. 8.

In this embodiment, the upper surface of leads 3 and the upper surface of the chip 4 are made flush and these are connected by the intermediate leads 12 with the supporting sheet faced down. On the lower surfaces of the protruded parts of the intermediate leads, solder or gold bumps are formed. The leads 3 and the electrodes of the semiconductor chip 4 are connected through the bumps. The preferred height of the bump is 20 to 50 µm, and the thickness of the supporting sheet 11' and the intermediate leads 12' are selected to be approximate 20 µm. In this embodiment the supporting sheet 11' is located between the intermediate leads 12' and the semiconductor chip 4/leads 3.

In this embodiment, it is necessary to perform the depressing of the bed 1 in order to make the surface of the chip to be the same level as the surface of the lead 3. However, a bedless leadframe which does not have a bed may be used.

In this embodiment, all connectitons are made of bumps, high reliability for connections is obtained and the assembly is easily automated.

Fig. 10 shows a sectional elevation of another embodiment of the present invention, and Fig. 11 shows a plan view of Fig. 10.

In this embodiment, intermediate leads 22 for wire bonding and intermedite leads 23 for bump connection are formed on the same supporting sheet 21. The intermediate leads 22 and 23 and bed 24 are composed of a conductive layer 26 made of aluminum or copper alloy and a multilayer plating layer 27 made by laminating nickel plating, copper plating and gold plating. This multilayer plating is performed after the patterning of the conductive layer. Each intermediate lead has a pad 25 for connection in its outer end.

A semiconductor chip 28 is die mounted on the bed with its face upward, and its electrodes 29 and corresponding intermediate leads are connected by bond wires 30. A semiconductor chip 31 is mounted on the intermediate leads 23 with its face down and the intermediate leads 23 and the chip 31 are bonded through solder or gold bumps 32.

In the case of wire bonding using intermediate leads, the pitch of inner ends of the intermediate lead conductors can be so reduced that the distance between the electrode and the inner end of the intermediate lead can be reduced and the wire length can also be reduced. As a result, the diameter of the bond wire can be further reduced. For example, if a wire has a diameter of 18 to 35 µm, the width of inner end of the intermediate leads is twice the wire diameter, and the distance between the electrode and the inner end can also be reduced less than the distance over which the bond wire can be hung straightly.

In all the embodiments described above, the thermal expansion of the supporting sheet preferably be approximately the same value as that of ceramic, i.e., 20 - 30 x $10^{-7}$/°C, to avoid generation of undesirable stress.

It is also preferable to use transparent material for the supporting sheet in order to make the positioning of the chip easier. That is, when a transparent sheet is used as the supporting sheet, it is possible to recognize the alignment between the bonding pads and the bumps formed on the intermediate leads. Consequently, positioning accuracy is increased remarkably. For this purpose, it is preferable to use low thermal expansion glass having a thermal expansion under 50 x $10^{-7}$/°C as the transparent material for the supporting sheet.

In the above embodiment, semiconductor chip can be mounted with either the face upward or downward.

Further, the pattern of the intermediate leads can be selected optionally, as long as they connect the electrode of the semiconductor chip to the lead.

Further, the bumps can be formed by transcription method using a screen printing method.

0210371

## CLAIMS:

1. A semiconductor device comprising a semiconductor chip (4, 28, 31) and a plurality of leads (3), the outer ends of the leads projecting from a package (6), characterized in that the inner ends of said leads are located apart from the side of the chip, and that the semiconductor device further comprises a plurality of intermediate leads (12) formed on an insulting supporting sheet (11), the inner ends of said intermediate leads being connected to the electrodes of said chip, the outer ends of said intermediate leads being connected to said inner ends of said leads corresponding to said electrods, and said intermediate leads being made narrower than said leads.

2. A semiconductor device according to claim 1, wherein said intermediate leads are formed by etching a metal layer formed on an insulating supporting sheet.

3. A semiconductor device according to claim 1, wherein said supporting sheet is polyimide sheet.

4. A semiconductor device according to claim 1, wherein said supporting sheet is made of transparent material.

5. A semiconductor device according to claim 4, wherein said transparent material is glass.

6. A semiconductor device according to claim 1, wherein said connection is performed by bumps.

7. A semiconductor device according to claim 6, wherein said bumps are made of solder or gold.

0210371

8. A semiconductor device according to claim 1, wherein said supporting sheet has an opening in the center thereof.

9. A semiconductor device comprising a semiconductor chip (4) and a plurality of leads (3), the outer ends of said leads projecting from a package (6), characterized in that the inner ends of the leads are located apart from the side of the chip, that the surface of said leads is flush with the surface of the electrodes of the semiconductor chip, and that the semiconductor device further comprises a plurality of intermediate leads (12') formed on an insulating supporting sheet which has an opening (14) in the center thereof, the inner ends protruding from the opening and the outer ends protruding from the side of the semiconductor chip, said intermediate lead being connected to said electrodes of the semiconductor chip and the leads placing said insulating supporting sheet between the intermediate leads and the leads/the substrate of the semiconductor chip.

10. A semiconductor device according to claim 9, wherein said semiconductor chip is mounted with its electrodes upward.

F I G. 1

F I G. 2

F I G. 3

F I G. 4

F I G. 5

F I G. 6

F I G. 7

F I G. 8

F I G. 9

F I G. 10

F I G. 11

European Patent
Office

**EUROPEAN SEARCH REPORT**

0210371

Application number

EP  86 10 7248

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | US-A-3 544 857  (R.C. BYRNE et al.) <br> * column  4, line 14 - column 5, line 54 * | 1-7 | H 01 L   23/48 |
| X | US-A-3 763 404  (A.D. AIRD) <br><br> * column 5, line 46 -  column  6, line 24 * | 1-3,8-10 | |
| A | PATENT ABSTRACTS OF JAPAN, vol. 5, no. 198 (E-87)[870], 16th December 1981; & JP - A - 56 122 139 (OKI DENKI KOGYO) 25-09-1981 | 1 | |

TECHNICAL FIELDS
SEARCHED (Int Cl 4)

H 01 L   23/48

The present search report has been drawn up for all claims

| Place of search | Date of completion of the search | Examiner |
|---|---|---|
| BERLIN | 22-08-1986 | GIBBS C.S. |